# EUROPEAN PATENT SPECIFICATION

(11) **EP 3 557 268 B1**
(45) Date of publication and mention of the grant of the patent: **17.05.2023**
(21) Application number: 16924071.0
(22) Date of filing: 15.12.2016
(51) Int. Cl.: G01R 31/327, G01R 31/333, H01H 33/00

(54) **TESTING APPARATUS FOR DC CIRCUIT BREAKER**
PRÜFVORRICHTUNG FÜR GLEICHSTROMSCHUTZSCHALTER
APPAREIL D'ESSAI DE DISJONCTEUR CC

(43) Date of publication of application: 23.10.2019
(73) Proprietor: Toshiba Energy Systems & Solutions Corporation, Saiwai-ku Kawasaki-shi Kanagawa 2120013 (JP)
(72) Inventor: HASHIMOTO, Yuhei, Tokyo 105-8001 (JP); MIYAZAKI, Kensaku, Tokyo 105-8001 (JP); KOYAMA, Hiroshi, Tokyo 105-8001 (JP)
(74) Representative: AWA Sweden AB
(86) International application number: PCT/JP2016/087348
(87) International publication number: WO 2018/109889

(56) References cited:
- EP-A1- 3 046 127
- JP-A- S5 757 267
- JP-A- S5 757 267
- JP-A- S59 120 871
- JP-A- S59 120 871
- JP-A- 2004 245 722
- JP-A- 2004 245 722
- JP-A- 2015 059 891
- BAOLIANG SHENG ED - HEDIO TATIZAWA ET AL: "A synthetic test circuit for current switching tests of HVDC circuit breakers", TRANSMISSION AND DISTRIBUTION CONFERENCE AND EXPOSITION, 2008. T&D. IEEE/PES, IEEE, PISCATAWAY, NJ, USA, 21 April 2008 (2008-04-21), pages 1-4, XP031250195, ISBN: 978-1-4244-1903-6

## Description

### FIELD

Embodiments of the present disclosure relate to a testing apparatus for examining the current breaking performance of a DC circuit breaker.

### BACKGROUND

In order to protect a system from a short-circuit accident due to lightning strike, etc., to an AC power system, a large capacity AC circuit breaker is applied. Regarding the current breaking testing scheme for this type of AC circuit breaker, a testing scheme called a synthetic testing scheme is known (see, for example, Non-Patent Document 1). This synthetic testing scheme is performed using a testing apparatus that has a current source circuit which supplies a short-circuit equivalent current to an accident current, and a voltage source circuit which supplies a high-frequency current and which applies a recovery voltage each connected in parallel with the AC circuit breaker subjected to the test.

More specifically, the current breaking test for the AC circuit breaker is performed through the following procedures (1) to (4).
(1) Supplying an AC short-circuit current equivalent to an accident current to the AC circuit breaker from the current source circuit.
(2) Supplying a high frequency current from the voltage source circuit immediately before the final zero value of said short-circuit current to cause superimposed currents to flow through the AC circuit breaker from the two circuits of the current source circuit and the voltage source circuit.
(3) Disconnecting the current source circuit from the AC circuit breaker at a time point which the short-circuit current becomes the final zero value.
(4) Subsequently, breaking the high-frequency current by the AC circuit breaker to produce the recovery voltage between the terminals of said AC circuit breaker.

Meanwhile, in order to protect a system from a short-circuit accident of a DC system, a DC circuit breaker is applied. The DC circuit breaker breaks an accident current due to a short-circuiting, etc. In order to surely protect the system, the DC circuit breaker requires a predetermined current breaking performance in accordance with the DC system where such the circuit breaker is applied.

As for a breaking testing scheme for a DC circuit breaker, there is a scheme in which a short-circuit accident current from an AC short-circuiting generator is rectified by a rectifier into a DC current, and an accident current at a time of a short-circuit simulating a DC system accident is supplied. Previous patent literature JP S59120871 A discloses break contact testing circuit obtained by connecting a first capacitor between the other terminal of a sample break contact and the ground while a resistor, a second capacitor, a trigger discharge gap and the like are connected thereto.

### CITATION LIST

### NON-PATENT LITERATURES

Non-Patent Document 1: Institute of Electrical Engineers of Japan, Japanese Electrotechnical Committee Standards, AC Circuit Breaker, JEC-2300-1998

### SUMMARY

In recent years, however, DC circuit breakers are becoming to have a large capacity. Hence, according to the conventional testing scheme that utilizes a rectifier, it is necessary to provide a large-capacity rectifier, and thus there is disadvantages that testing equipment increases in size and costs for installing the equipment remarkably increases. Moreover, the testing scheme that utilizes a large-capacity rectifier has a technical problem in test efficiency. Therefore, it is not easy to apply the conventional testing scheme that utilizes a rectifier, and another testing scheme is desired.

In this point, a testing apparatus applied to the synthetic testing scheme for an AC circuit breaker may be applied to a current breaking performance test for a DC circuit breaker. However, in this case, because of a difference between AC and DC, the current breaking performance test cannot be performed through the above-described procedures. That is, according to the above-described synthetic testing scheme, either of the current and the voltage equivalent to an accident of a DC system cannot be applied, and thus the current breaking performance of a DC circuit breaker cannot be examined.

A testing apparatus for a DC circuit breaker according to embodiments of the present disclosure has been made to address the above technical problems, and an objective is to provide a testing apparatus for a DC circuit breaker which examines a current breaking performance of the DC circuit breaker.

In order to achieve the above objective, a testing apparatus for a DC circuit breaker according to claim 1 is disclosed.

### BRIEF DESCRIPTION OF DRAWINGS

FIG. 1 is a circuit diagram illustrating a structure of a testing apparatus for a DC circuit breaker according to an embodiment;
FIG. 2 is a current waveform diagram in a process of performing a short-circuit current breaking in a testing method that utilizes the testing apparatus for the DC circuit breaker according to the embodiment; and
FIG. 3 is a voltage waveform diagram in the process of performing the short-circuit current breaking in the testing method that utilizes the testing apparatus for the DC circuit breaker according to the embodiment.

### DETAILED DESCRIPTION

### [1. Embodiment]

### [1-1. Entire Structure]

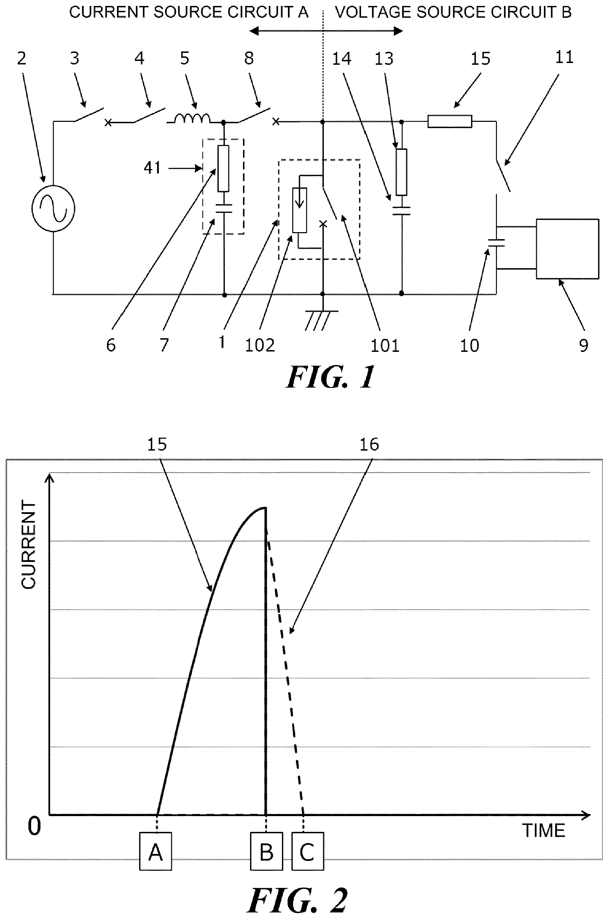

The invention is defined by the appended independent claim. Embodiments are set forth in the appended dependent claims and in the following description and drawings. In the following description, a testing apparatus for a DC circuit breaker according to this embodiment and a testing method for the DC circuit breaker that utilizes said testing apparatus will be described with reference to FIGS. 1 to 3. FIG. 1 is a circuit diagram illustrating a structure of the testing apparatus for the DC circuit breaker according to this embodiment.

The testing apparatus for a DC circuit breaker is an apparatus to test a DC current breaking performance of a DC circuit breaker 1 subjected to the test. This testing apparatus includes two power supply circuits to be described later in order to simulate an accident that occurs in a DC system. Example DC systems are DC power transmission system, such as a long-distance power transmission or a power transmission between electricity companies, a DC distribution, such as a building or a large-scale commercial facility, and a DC system such as an electric railroad.

The DC circuit breaker 1 is a circuit breaker that breaks a DC current which flows in the DC circuit breaker 1. An example DC circuit breaker 1 subjected to the test is the DC circuit breaker 1 that has a rated breaking current of several kA to several ten kA, and has a rated voltage of several ten kV to several hundred kV. The DC circuit breaker 1 includes a breaker unit 101, and an energy absorbing unit 102. The breaker unit 101 and the energy absorbing unit 102 are provided in parallel with each other.

The breaker unit 101 is a switch that breaks or carries a current which flows through a circuit. The breaker unit 101 includes a semiconductor circuit breaker that uses semiconductor elements. This breaker unit 101 includes, in addition to the semiconductor circuit breaker, a mechanical circuit breaker that mechanically breaks or carries a current.

The energy absorbing unit 102 is a so-called surge absorber (also referred to as the surge absorber 102 below) . The surge absorber 102 absorbs a transient high-voltage energy applied to the surge absorber 102. The surge absorber 102 restricts the magnitude of the voltage after the breaker unit 101 breaks the current.

Two different power supply circuits are connected in parallel with the DC circuit breaker 1. That is, the testing apparatus according to this embodiment includes a current source circuit A that supplies an AC current to the DC circuit breaker 1, and a voltage source circuit B that applies a recovery voltage to the DC circuit breaker 1, and these circuits A and B are connected in parallel with the DC circuit breaker 1.

### [1-2. Detailed Structure]

### (Current Source Circuit)

The current source circuit A supplies an AC current to the DC circuit breaker 1. The current source circuit A includes a short-circuiting generator 2, a protective circuit breaker 3, an input switch 4, a reactor 5, a resistor 6, a capacitor 7, and an auxiliary circuit breaker 8.

The short-circuiting generator 2 is a generator that produces a short-circuit current. The short-circuit current produced by the short-circuiting generator 2 is an AC current. The frequency of this AC current is a frequency in which a time of the 1/4 cycle of the AC current is equal to or longer than a current breaking time by the DC circuit breaker 1. The short-circuit current produced by the short-circuiting generator 2 is output to the DC circuit breaker 1 via the reactor 5.

Provided between the short-circuiting generator 2 and the DC circuit breaker 1 are the protective circuit breaker 3, the input switch 4, and the reactor 5. The input switch 4 is a switch that connects the short-circuiting generator 2 to a test circuit, and changes the connection and disconnection of the short-circuiting generator 2 relative to the DC circuit breaker 1. The protective circuit breaker 3 is a circuit breaker that breaks the AC short-circuit current which flows through the current source circuit A. The protective circuit breaker 3 breaks the current at a current zero point of the AC short-circuit current.

The current source circuit A is further provided with the auxiliary circuit breaker 8 and a surge absorbing unit 41. The auxiliary circuit breaker 8 is connected to the short-circuiting generator 2, and changes connection and disconnection states between the DC circuit breaker 1 subjected to the test and the short-circuiting generator 2. The auxiliary circuit breaker 8 is, for example, a mechanical circuit breaker. The auxiliary circuit breaker 8 is provided at a side closest to the DC circuit breaker 1 among the components in the current source circuit A. When the auxiliary circuit breaker 8 is in an input state, a current can be supplied to the DC circuit breaker 1 from the short-circuiting generator 2, but when the auxiliary circuit breaker 8 is in a current broken state, the current source circuit A is disconnected from the DC circuit breaker 1, and no current is supplied to the DC circuit breaker 1 from the short-circuiting generator 2. However, when the auxiliary circuit breaker 8 is a mechanical circuit breaker, even after the auxiliary circuit breaker 8 becomes an open state, arc is produced between electrodes for a predetermined time period.

The surge absorbing unit 41 is connected to the auxiliary circuit breaker 8, and absorbs surge that is produced when the auxiliary circuit breaker 8 breaks the current. The surge absorbing unit 41 has the above-described resistor 6 and capacitor 7 connected in series with each other, and the capacitor 7 absorbs surge via the resistor 6, facilitating a current breaking by the auxiliary circuit breaker 8.

### (Voltage Source Circuit)

The voltage source circuit B applies a recovery voltage to the DC circuit breaker 1. The voltage source circuit B includes a voltage source capacitor 10, a charging device 9, an actuation switch 11, a resistor 12, a resistor 13, and a capacitor 14.

The voltage source capacitor 10 is a DC capacitor that becomes the voltage source of the voltage source circuit B. The voltage source capacitor 10 applies the recovery voltage to the DC circuit breaker 1 via the resistor 12 when the actuation switch 11 is in an input state. The voltage source capacitor 10 has a capacitance capable of supplying a part of a short-circuit current at the time of an accident of a DC system which the DC circuit breaker 1 is provided. Regarding the recovery voltage, other capacitors may also be utilized to adjust a transient recovery voltage.

The charging device 9 is connected in parallel with the voltage source capacitor 10, and charges the voltage source capacitor 10. The actuation switch 11 is a component that changes ON and OFF of application states of the voltage from the voltage source capacitor 10.

The voltage source circuit B includes a transient circuit (a CR circuit) that has the voltage source capacitor 10 as a DC voltage source. That is, the resistor 12, the resistor 13, and the capacitor 14 are connected in series to the voltage source capacitor 10, and thus the transient circuit is formed. This transient circuit causes a transient phenomenon, and adjusts the voltage applied to the DC circuit breaker 1.

The capacitor 14 is a voltage adjusting capacitor that adjusts the voltage supplied by the voltage source capacitor 10. In this case, the capacitor 14 is used together with the voltage source capacitor 10 to adjust the voltage applied to the DC circuit breaker 1 at the time of the accident of the DC system accident. The resistor 13 is for adjusting the transient phenomenon.

The resistor 12 is a resistor for adjusting the current and the voltage which are supplied to the DC circuit breaker 1 from the voltage source circuit B. The resistance value of the resistor 12 is a value which causes the current value supplied by the voltage source circuit B to the DC circuit breaker 1 to be a minimal current value which is equal to or smaller than 1/1000
of the current equivalent to the accident current which is supplied by the current source circuit A to the DC circuit breaker 1. For example, when the rated voltage of the DC circuit breaker 1 is smaller than 50 kV, the voltage of the voltage source capacitor 10 is 50 kV, and the current equivalent to the accident current is 1 kA, the current supplied from the voltage source circuit B is equal to or smaller than 1A, and the resistance value of the resistor 12 may be kS2. As described above, since the resistor 12 has a quite large resistance value that is equal to or larger than several 10 kS2, and only the minimal current is supplied to the DC circuit breaker 1 from the voltage source circuit B in comparison with the current equivalent to the accident current, the voltage drop at the voltage source capacitor 10 is suppressed. Note that the resistance value of the resistor 12 may be determined based on the recovery voltage supplied to the DC circuit breaker 1 and the rated power of the resistor 12.

### [1-3. Testing Method]

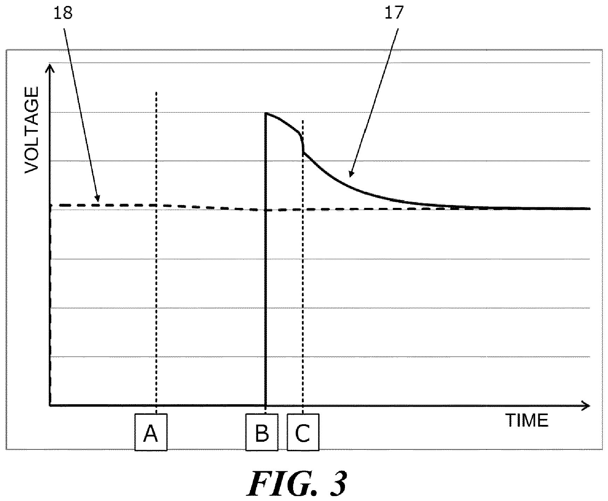

A testing method is a method for examining the current breaking performance of the DC circuit breaker that includes a semiconductor circuit breaker for the short-circuit accident current in a DC system, and is performed using the testing apparatus in the above-described embodiment. The testing method will be described with reference to FIGS. 2 and 3. FIG. 2 is a current waveform diagram in a process of performing a short-circuit current breaking by the testing method. FIG. 3 is a voltage waveform diagram in the process of performed the short-circuit current breaking by the testing method.

At a time at which the test starts, the DC circuit breaker 1 is connected to the testing apparatus, the protective circuit breaker 3 and the auxiliary circuit breaker 8 are in the close state, the input switch 4 and the actuation switch 11 are in the open state, the short-circuiting generator 2 is in an excited state at a predetermined voltage in advance, and the voltage source capacitor 10 is in a state charged to a predetermined voltage by the charging device 9.

First, as illustrated in FIG. 2, at a time point A, the input switch 4 is changed to a close state, and an AC current is supplied to the breaker unit 101 of the DC circuit breaker 1 from the short-circuiting generator 2. This AC current is 0 A at the time point A, and then starts increasing. This AC current has its magnitude adjusted by the reactor 5. Note that the reactor 5 accumulates energy by the short-circuiting generator 2.

Next, at an arbitrary time point between the time point A and a time point B, the actuation switch 11 is input. The input timing of this actuation switch 11 may be executed prior to the current breaking by the breaker unit 101 of the DC circuit breaker 1, and includes the same timing as the current breaking or the timing immediately before the current breaking. In this case, as illustrated in FIG. 3, the input timing of the actuation switch 11 is the time point A.

When the actuation switch 11 is input, a DC current defined by the voltage source capacitor 10 and the resistor 12 is supplied to the breaker unit 101. That is, input of the actuation switch 11 causes the voltage source circuit B to be connected to the DC circuit breaker, and the DC current from the voltage source circuit B is superimposed on the AC current from the short-circuiting generator 2. However, the DC current supplied from the voltage source circuit B is equal to or smaller than 1/1000, preferably 1/10000 relative to the AC current supplied from the current source circuit A, and is a minimal current. As illustrated in FIG. 2, this superimposed current 15 is supplied to the breaker unit 101 and increases.

Moreover, input of the actuation switch 11 causes the voltage source circuit B to be connected to the DC circuit breaker 1, and thus the voltage is applied to the DC circuit breaker 1. Since the primary power supply of the voltage source circuit B is the voltage source capacitor 10, the voltage of the voltage source capacitor 10 decreases by the discharging thereof. However, according to this embodiment, since the resistor 12 has a very large resistance value that is substantially several 10 kS2, as illustrated in FIG. 3, the voltage drop of the voltage source capacitor 10 is very gradual. In other words, the voltage of the voltage source capacitor 10 maintains the voltage value that has been charged in advance.

After the current becomes the superimposed current 15, at the time point B at which said current 15 becomes equal to or greater than the current equivalent to the accident current, the breaker unit 101 and the auxiliary circuit breaker 8 are opened to chop the current, thereby breaking the current 15. According to this embodiment, the current 15 is broken at a time point at which the current reaches the current equivalent to the accident current.

By this current breaking, the transient voltage by the reactor 5 is applied to between the electrodes of the DC circuit breaker 1. That is, since the auxiliary circuit breaker 8 is a mechanical circuit breaker, arc discharge is produced between the contacts even if the contacts of the auxiliary circuit breaker 8 are opened and separated from each other, and the transient voltage is applied by the reactor 5 to between the electrodes of the DC circuit breaker 1. Regarding this transient voltage, the surge absorber 102 absorbs an overvoltage. As illustrated in FIG. 2, this absorbing action appears in the form of a surge absorber current 16. That is, while the surge absorber current 16 is flowing, the arc discharging is continued at the auxiliary circuit breaker 8.

Note that the transient voltage by the reactor 5 is also applied to the capacitor 14. However, the majority of the energy corresponding to the transient voltage is absorbed by the surge absorber 102.

When the absorbing action for the overvoltage by the surge absorber 102 ends at a time point C, the current source circuit A is disconnected from the DC circuit breaker 1 by the auxiliary circuit breaker 8. After the time point C, as illustrated in FIG. 3, the voltage defined by the voltage source capacitor 10 of the voltage source circuit B, the resistor 12, the resistor 13, and the capacitor 14 is applied to the DC circuit breaker 1 as a voltage 17 applied to between the electrodes of the DC circuit breaker 1. The voltage of the voltage source capacitor 10 at the time point C is a voltage equal to or greater than the voltage equivalent to the voltage applied to the DC circuit breaker 1 at the time of the current breaking due to an accident in the DC system.

As described above, by connecting the voltage source circuit B to the DC circuit breaker 1 at a stage to supply the current that is smaller than the current equivalent to the accident current to the DC circuit breaker 1 and before the current breaking, both the current supply and the current application is performed to the DC circuit breaker 1. Accordingly, at the time of the current breaking, since the current equivalent to the accident current due to an accident in the DC system and the predetermined recovery voltage equivalent to the voltage applied due to said accident can be applied to the DC circuit breaker 1, the current breaking performance of the DC circuit breaker 1 can be examined.

In particular, since the resistor 12 has a very large resistance value, even when the voltage source circuit B is connected to the DC circuit breaker 1 before the time point B at which the breaker unit 101 of the DC circuit breaker 1 is opened, a current hardly flows to the DC circuit breaker 1 from the voltage source circuit B. Hence, the voltage of the voltage source capacitor 10 can be maintained, and thus a stable recovery voltage can be supplied. This enables to examine the current breaking performance and the voltage withstand performance after the current breaking through a single test.

### [Modified Example of Testing Method]

In the above-described testing method, although the input timing of the actuation switch 11 is set to be prior to the current breaking by the DC circuit breaker 1 and the voltage source circuit B is connected to the DC circuit breaker 1 prior to said current breaking, it is appropriate as long as, , the current equivalent to the accident current and the predetermined recovery voltage equivalent to a voltage due to the accident current breaking are applied to the DC circuit breaker 1 at the time of current breaking, and the connection timing of the voltage source circuit B to the DC circuit breaker 1 may be simultaneous with such a current breaking. This also enables application of the current equivalent to the accident current and the predetermined recovery voltage equivalent to a voltage due to the accident current breaking at the time of the current breaking.

### [1-4. Effects]

(1) The testing apparatus for the DC circuit breaker according to this embodiment is a testing apparatus for the DC circuit breaker that breaks a DC current, and includes the current source circuit A that supplies a current equivalent to an accident current to the DC circuit breaker 1, and the voltage source circuit B that supplies a recovery voltage to the DC circuit breaker 1, and the voltage source circuit B includes the voltage source capacitor 10 to apply the recovery voltage, and the first resistor 12 that is connected in series with the voltage source capacitor 10.
   This enables to examine the current breaking performance of the DC circuit breaker 1 using the current source circuit A, and by providing the resistor 12 in the voltage source circuit breaker B, the stable recovery voltage is applicable to the DC circuit breaker 1 so that a voltage withstand capability test can be carried out. Hence, according to this embodiment, the current breaking performance of the DC circuit breaker 1 and the voltage withstand capability after the current breaking can be tested. Therefore, according to this embodiment, the testing apparatus for the DC circuit breaker which examines the current breaking performance of the circuit breaker is provided.
(2) The resistance value of the resistor 12 is a value which causes the current supplied to the DC circuit breaker 1 by the voltage source circuit B to be equal to or smaller than 1/1000 of the current equivalent to the accident current. This suppresses the voltage drop of the voltage source capacitor 10, enabling a supply of a stable and high recovery voltage after the current breaking. Hence, a highly reliable test can be carried out.
(3) The current source circuit B includes the short-circuiting generator 2 which is connected to the DC circuit breaker 1 and which generates an AC current, a input switch 4 which is connected between the short-circuiting generator 2 and the DC circuit breaker 1 and which breaks or carries the current, the reactor 5 which is connected between the short-circuiting generator 2 and the DC circuit breaker 1, and the mechanical auxiliary circuit breaker 8 which is connected between the reactor 5 and the DC circuit breaker 1.
   This enables a supply of the current equivalent to the accident current to the DC circuit breaker 1. That is, an accident in the DC system where the DC circuit breaker 1 is provided can be simulated, and the current breaking performance of the DC circuit breaker 1 can be examined. Moreover, as for this current source circuit B, the same facility as the current source circuit of the large-power testing facility for general AC circuit breakers is applicable. Hence, since the current breaking test for the DC circuit breaker 1 is carried out using the conventional testing apparatus applied for the synthetic testing method for AC circuit breakers, it is unnecessary to additionally prepare facility costs and a site where the facility is installed. Moreover, it is also unnecessary to install large-capacity DC generator and rectifier which are expensive and large sizing. Accordingly, the inexpensive testing apparatus for the DC circuit breaker 1 is can be obtained, which is advantageous in view of economic efficiency.
(4) The voltage source circuit B includes the resistor 13 connected in series with the resistor 12, and the capacitor 14 connected in series with the resistor 13. Accordingly, the recovery voltage supplied to the DC circuit breaker 1 can be adjusted.

### [2. Other Embodiments]

Although several embodiments of the present disclosure have been described in this specification, such embodiments are merely presented as examples, and are not intended to limit the scope of the present disclosure. The above-described embodiments can be carried out in other various forms, and various omissions, replacements, and modifications can be made thereto without departing from the scope of the present disclosure. Such an embodiment and a modified form thereof are within the scope of the present disclosure, and also within the scope of the invention as recited in the appended claims.

The above-described testing method at an instant of current breaking or the testing method after the current breaking may be achieved by providing a control unit instead of the execution by a work engineer. That is, the control unit is a computer apparatus that includes a recording medium having stored therein a program for a sequence management, and by executing such a program, a command for connection or disconnection may be output to the respective components of the circuits A and B at a predetermined timing.

Although the surge absorber 102 is provided in the DC circuit breaker 1, the surge absorber may be provided outside the DC circuit breaker 1 as long as being provided in parallel with the breaker unit 101.

### REFERENCE SIGNS LIST

- 1: DC circuit breaker
- 101: Breaker unit
- 102: Surge absorber
- A: Current source circuit
- 2: Short-circuiting generator
- 3: Protective circuit breaker
- 4: Input switch
- 5: Reactor
- 6: Resistor
- 7: Capacitor
- 8: Auxiliary circuit breaker
- 41: Surge absorbing unit
- B: Voltage source circuit
- 9: Charging device
- 10: Voltage source capacitor
- 11: Actuation switch
- 12: Resistor
- 13: Resistor
- 14: Capacitor
- 15: Current
- 16: Surge absorber current
- 17: Recovery voltage
- 18: Voltage source capacitor voltage

## Claims

1. A testing apparatus (A, B) for a DC circuit breaker (1) that
breaks a DC current, the testing apparatus comprising:
a current source circuit (A) that supplies a current (15) equivalent to an accident current to the DC circuit breaker (1); and
a voltage source circuit (B) that supplies a recovery voltage (17) to the DC circuit breaker (1),
wherein the current source circuit (A) comprises:
a short-circuiting generator (2) which is connected to the DC circuit breaker (1), and which generates an AC current;
an input switch (4) unit which is connected between the short-circuiting generator (2) and the DC circuit breaker (1), and which breaks or carries the current;
a reactor (5) to apply a transient voltage to the DC circuit breaker (1), the reactor (5) being which is connected between the short-circuiting generator (2) and the DC circuit breaker (1); and
a mechanical circuit breaker which is connected between the reactor (5) and the DC circuit breaker (1),
wherein the voltage source circuit (B) comprises:
a voltage source capacitor (10) to apply the recovery voltage (17); and
a first resistor (12) that is connected in series with the voltage source capacitor (10), wherein a resistance value of the first resistor (12) is a value that causes the current which is supplied to the DC circuit breaker (1) by the voltage source circuit (B) to be equal to or smaller than 1/1000 of the current equivalent to the accident current.

2. The testing apparatus (A, B) for a DC circuit breaker (1) according to claim 1, wherein the voltage source circuit (B) comprises:
a second resistor (13) connected in series with the first resistor (12);
a capacitor (14) connected in series with the second resistor (13); and
a switch that changes connection and disconnection of the voltage source capacitor (10) relative to the DC circuit breaker (1).

3. The testing apparatus (A, B) for a DC circuit breaker (1) according to claim 2, further comprising a control unit that controls the input switch (4) unit, the mechanical circuit breaker, and the switch,
wherein the control unit causes:
the input switch (4) unit and the mechanical circuit breaker to connect the short-circuiting generator (2) to the DC circuit breaker (1);
the switch to connect the voltage source capacitor (10) to the DC circuit breaker (1) prior to the current breaking by the DC circuit breaker (1); and
the input switch (4) unit and the mechanical circuit breaker to break the current simultaneously with the current breaking by the DC circuit breaker (1).

## Patentansprüche

1. Prüfvorrichtung (A, B) für einen Gleichstromschutzschalter (1), der einen Gleichstrom unterbricht, wobei die Prüfvorrichtung umfasst:
eine Stromquellenschaltung (A), die einen Strom (15) äquivalent zu einem Unfallstrom an den Gleichstromschutzschalter (1) liefert; und
eine Spannungsquellenschaltung (B), die eine Wiederkehrspannung (17) an den Gleichstromschutzschalter (1) liefert,
wobei die Stromquellenschaltung (A) umfasst:
einen Kurzschlussgenerator (2), der mit dem Gleichstromschutzschalter (1) verbunden ist und einen Wechselstrom erzeugt;
eine Eingangsschaltereinheit (4), die zwischen dem Kurzschlussgenerator (2) und dem Gleichstromschutzschalter (1) geschaltet ist und den Strom unterbricht oder führt;
eine Drossel (5) zum Anlegen einer transienten Spannung an den Gleichstromschutzschalter (1), wobei die Drossel (5) zwischen dem Kurzschlussgenerator (2) und dem Gleichstromschutzschalter (1) geschaltet ist; und
einen mechanischen Schutzschalter, der zwischen der Drossel (5) und dem Gleichstromschutzschalter (1) geschaltet ist,
wobei die Spannungsquellenschaltung (B) umfasst:
einen Spannungsquellenkondensator (10) zum Anlegen der Wiederkehrspannung (17); und
einen ersten Widerstand (12), der mit dem Spannungsquellenkondensator (10) in Reihe geschaltet ist, wobei ein Widerstandswert des ersten Widerstands (12) ein Wert ist, der bewirkt, dass der Strom, der dem Gleichstrom-Schutzschalter (1) durch die Spannungsquellenschaltung (B) zugeführt wird, gleich oder kleiner als 1/1000 des Stroms ist, der dem Unfallstrom entspricht.

2. Prüfvorrichtung (A, B) für einen Gleichstromschutzschalter (1) nach Anspruch 1, wobei die Spannungsquellenschaltung (B) umfasst:
einen zweiten Widerstand (13), der mit dem ersten Widerstand (12) in Reihe geschaltet ist;
einen Kondensator (14), der mit dem zweiten Widerstand (13) in Reihe geschaltet ist; und
einen Schalter, der eine Verbindung und Trennung des Spannungsquellenkondensators (10) bezüglich des Gleichstromschutzschalters (1) ändert.

3. Prüfvorrichtung (A, B) für einen Gleichstromschutzschalter (1) nach Anspruch 2, ferner umfassend eine Steuereinheit, die die Eingangsschaltereinheit (4), den mechanischen Schutzschalter und den Schalter steuert,
wobei die Steuereinheit bewirkt:
dass die Eingangsschaltereinheit (4) und der mechanische Schutzschalter den Kurzschlussgenerator (2) mit dem Gleichstromschutzschalter (1) verbinden;
dass der Schalter den Spannungsquellenkondensator (10) mit dem Gleichstromschutzschalter (1) verbindet, vor der Stromunterbrechung durch den Gleichstromschutzschalter (1); und
dass die Eingangsschaltereinheit (4) und der mechanische Schutzschalter den Strom gleichzeitig mit der Stromunterbrechung durch den Gleichstromschutzschalter (1) unterbrechen.

## Revendications

1. Appareil de test pour un disjoncteur CC (1) qui coupe un courant continu, l'appareil de test comprenant :
un circuit de source de courant (A) qui fournit un courant (15) équivalent à un courant accidentel au disjoncteur CC (1) ; et
un circuit de source de tension (B) qui fournit une tension de rétablissement (17) au disjoncteur CC (1),
dans lequel le circuit de source de courant (A) comprend :
un générateur de court-circuit (2) qui est connecté au disjoncteur continu (1) et qui génère un courant alternatif ;
une unité de commutateur d'entrée (4) qui est connectée entre le générateur de court-circuit (2) et le disjoncteur CC (1) et qui coupe ou transporte le courant ;
une réactance (5) pour appliquer une tension transitoire au disjoncteur CC (1), dans lequel la réactance (5) est connectée entre le générateur de court-circuit (2) et le disjoncteur CC (1) ; et
un disjoncteur mécanique qui est connecté entre la réactance (5) et le disjoncteur CC (1),
dans lequel le circuit de source de tension (B) comprend :
un condensateur de source de tension (10) pour appliquer la tension de rétablissement (17) ; et
une première résistance (12) qui est connectée en série avec le condensateur de source de tension (10), dans lequel une valeur de résistance de la première résistance (12) est une valeur qui provoque le courant qui est fourni au disjoncteur CC (1) par le circuit de source de tension (B) pour être égal ou inférieur à 1/1000 du courant équivalent au courant accidentel.

2. Appareil de test (A,B) pour un disjoncteur CC (1) selon la revendication 1, dans lequel le circuit de source de tension (B) comprend :
une deuxième résistance (13) connectée en série avec la première résistance (12) ;
un condensateur (14) connecté en série avec la deuxième résistance (13) ; et
un commutateur qui modifie la connexion et la déconnexion du condensateur de source de tension (10) par rapport au disjoncteur CC (1).

3. Appareil de test (A, B) pour un disjoncteur CC (1) selon la revendication 2, comprenant en outre une unité de commande qui commande l'unité de commutateur d'entrée (4), le disjoncteur mécanique et le commutateur,
dans lequel l'unité de commande amène :
l'unité de commutateur d'entrée (4) et le disjoncteur mécanique à connecter le générateur de court-circuit (2) au disjoncteur CC (1) ;
le commutateur à connecter le condensateur de source de tension (10) au disjoncteur CC (1) avant la coupure de courant par le disjoncteur CC (1) ; et
l'unité de commutateur d'entrée (4) et le disjoncteur mécanique à couper le courant simultanément à la coupure de courant par le disjoncteur CC (1).
